# EUROPEAN PATENT APPLICATION

(11) **EP 1 063 825 A2**
(43) Date of publication of application: **27.12.2000**
(21) Application number: 00830423.0
(22) Date of filing: 15.06.2000
(51) Int. Cl.: H04L 27/36, H04L 25/03, H03F 3/32, H04B 1/04

(54) **Predistortion system for linearising power amplifiers**

(30) Priority: 17.06.1999 IT MC990052
(71) Applicant: Itelco - S.p.A., Orvieto (TR) (IT)
(72) Inventor: Andreoli, Sante, Pescara (IT); Betti, Roberto, Viterbo (IT); Fumi, Eugenio, Orvieto (TR) (IT); Banelli, Paolo, Perugia (IT)
(74) Representative: Baldi, Claudio

(57) **Abstract**

The present invention concerns a mixed baseband-IF predistortion system for linearising power amplifiers characterised by at least one IF predistortion actuating circuit and by at least a baseband predistortion computing circuit that controls the IP predistortion actuating circuit.

## Description

The present patent application for industrial invention concerns a mixed baseband-IF predistortion system used to linearise amplifiers that exhibit non-linear distortion phenomena.

An instantaneous non-linear amplifier can be generally modelled through its AM/AM and AM/PM distortion curves [1], [2].

Both types of non-linear distortions produce the spectral regrowth of the amplifier output. The spectral regrowth can be classified into the two following categories:
In-band intermodulations
Out-band intermodulations.

In-band intermodulations cannot be eliminated with linear filtering and are responsible for the signal-to-noise ratio degradation and, consequently, for the Bit Error Rate (BER) degradation in digital communication systems.

Out-band intermodulations generate the interference between adjacent channels and can be filtered out at the amplifier output, although with a certain output power penalty due to filter insertion losses.

Baseband predistortion is one of the known techniques used to counteract AM/AM and AM/PM distortions [2][3] and its digital adaptive implementation has been widely investigated in the last few years [4] [5] [6] [7].

The IF predistortion is another well known technique used to compensate for AM/AM and AM/PM non linearities introduced by an amplifier [8], [9], [10].

The IF predistortion technique distorts the instantaneous amplitude of a real signal generated by the modulation of a complex baseband signal at an intermediate frequency (IF) that lies between the baseband frequency and the transmission radio frequency (RF).

On the contrary, the Baseband Predistortion works directly on the complex baseband signal, distorting its instantaneous envelope.

The theoretical equivalence of the two techniques and their mutual analytical relations are known in the literature [2].

These techniques are different, instead, from the technological point of view: the baseband predistortion generally uses digital technology, while the IF predistortion takes advantage of analogue devices, with a consequent limited precision in the precorrection strategy.

Nevertheless, it may be theoretically possible to realise an IF predistorter that employs only digital technologies. This approach would require the use of digital components capable to work at sampling frequencies higher than those required by an equivalent baseband predistorter.

Consequently, it is not generally advantageous, if not even technologically impossible, to realise a completely digital IF predistorter capable of working on large bandwidth signals.

At the same time, however, the realisation of an IF predistorter characterised by a precorrection accuracy equal to the one guaranteed by its digital baseband implementation should be preferred to that of a baseband predistorter when such a predistorter replaces the old analogue IF predistorter employed in the existing transmission systems.

In such a case, the replacement of the old predistorter would not modify the overall transmitter architecture, unlike from what would happen with a baseband predistorter, with evident advantages both in terms of maintenance costs and designing time.

None of the known predistortion schemes propose mixed solutions for baseband and IF predistortion strategy.

Another aspect to be highlighted is that even an ideally predistorted amplifier (both by baseband or IF predistortion) can be modelled as a device (hereinafter defined as soft-limiter) that limits the signal envelope below a certain maximum value.

Therefore, the saturation non-linear distortion cannot be avoided whenever the signal modulation is characterised by a non constant envelope and the amplifier does not work with an adequate difference between the maximum and the mean output power.

This situation is typical of multicarrier signals, which are characterised by an high peak-to-mean power ratio.

Consequently, their maximum signal envelope is usually reduced with an operation (defined as "clipping") in order to obtain a more efficient power amplification, even if paying the price of a reduced spectral purity.

The difference between the maximum and the working amplifier output power is commonly defined as back-off.

The aim of the present invention is to realise a predistortion system to linearise amplifiers, working on signals that are modulated at an intermediate frequency IF and exploiting the precorrection accuracy typical of digital implementations.

The invention consists in the realisation of a device that, by exploiting the baseband representation of the input signal, is capable of calculating the amplitude and phase predistortion that are necessary to linearise a non-linear amplifier by means of a baseband digital device, implementing the said predistortion at IF by using analogue devices.

According to the present invention, the said objective is reached by a baseband digital system that includes at least a circuit for the predistortion computing, a digital delay line and a Digital-to-Analogue converter and by an analogue system that modifies the gain and the phase of the IF modulated input signal as a function of the output of the baseband digital system.

This solution allows for reducing the complexity of a completely digital implementation of the IF predistorter, although maintaining almost the same predistortion quality of a completely digital baseband predistorter.

Another purpose of the present invention is to realise a predistortion system capable of reducing the cost and complexity of, or even eliminating, the amplifier output filters used to reduce the out band spectral regrowth.

According to the present invention, this objective is achieved by including in the predistortion system also a pre-clipping circuit and at least a filter that eliminates the out band spectral regrowth.

The term "pre-clipping" term is used to indicate that the clipping operation must be performed before the predistorting one.

A further purpose of the present invention is to provide adaptation to the predistortion system.

According to the present invention, this objective is achieved by including in the predistortion system both an input-output error circuit that provides the values to modify the action of the said predistortion circuit and a timing circuit to synchronise the input with the output of the system.

Following are some considerations to better understand the reasons why clipping is introduced before the predistortion circuit:
Both the predistortion circuit and the RF amplifier introduce non-linear distortions (i.e. AM/AM and AM/PM) that only depend on the baseband signal envelope and, consequently, on the instantaneous signal power;
The ideal combination of the predistortion circuit with the amplifier gives rise to an overall system characterised by a completely cancelled AM/PM curve and by a residual AM/AM curve that acts as soft limiter of the baseband signal envelope.

This means that the RF output of the ideally predistorted amplifier is equivalent to the RF modulation of a complex baseband signal whose envelope is passed through a soft limiter device.

The residual distortion introduced by the soft limiter depends on the signal peak-to-mean power ratio and on the input back off to the predistorted system (soft limiter).

A residual distortion is introduced whenever the input back-off to the predistorted system is lower than the peak-to-mean power ratio of the signal.

Distortions become more evident when the input signal is characterised by a high peak-to-mean power ratio.

If the predistorted amplifier introduces clipping on the signal envelope, the consequent spectral regrowth will degrade the signal both with respect to the signal-to-noise ratio and the adjacent channel interference.

The signal-to-noise ratio degradation for a fixed input back off cannot be avoided because it depends on the in band intermodulations.

On the contrary, the linear filtering of the out band intermodulations produced by clipping can reduce the adjacent channel interferences.

If the predistorted amplifier generates clipping, the only way to reduce the adjacent channel interference is to introduce a RF filter at the amplifier output.

This results in a significant expense in terms of equipment costs and a reduction of the available output power due to filter insertion losses.

The present invention is characterised in that it realises dipping at baseband on the signal envelope, which is analogous to the one that would be introduced by the predistorted amplifier.

Such an approach allows for the baseband counteraction of the adjacent channel interference introduced by the clipping circuit by means of devices hereinafter defined as "post-clipping filters".

This allows for obtaining the same residual adjacent channel interference, for a given output power, that would be obtained by using RF selective filters, with a significant reduction of the system costs.

However, both clipping and post-clipping filtering must be implemented before the predistortion circuit, in order not to vanish the predistorter action. In this way, the output of the post-clipping filters represents the baseband equivalent of the best residual distorted signal that can be obtained at the predistorted amplifier output.

In order to clarify the notation used in the description below and in the enclosed figures, we remind that an RF signal *x*(*t*) modulated at an RF frequencyfo = ωo2π can be analytically represented by the following expression:x(t) = Rx(t)cos{ωot+θx(t)} where *R*ₓ(*t*) and θₓ(t) represent the instantaneous envelope and the instantaneous phase of the modulating signal, respectively. The signal can be equivalently represented at baseband by the complex signal *x^{&}*(*t*) defined in polar notation as:x(t) = Rx(t)·ejθx(t)

The complex signal *x^{&}*(*t*) can also be represented by its Cartesian notation as:x(t) = xI(t) + jxQ(t) where *x*_{I}(*t*) and *x*_{Q}(*t*) are the so-called In-phase and Quadrature signal components, respectively, and are related to the polar notation by the following expressions:xI(t) = Rx(t)·cos[θx(t)]xQ(t) = Rx(t)·sen[θx(t)]

The relationship between the signal *x*_{RF}(*t*) modulated at a frequencyfRF = ωRF2π and its complex baseband equivalent is expressed by the following analytical expression:xRF(t) = Re{x(t)·ejωRFt} = xI(t)cos(ωRFt)-xQ(t)sin(ωRFt)

For major clarity the description continues with the architecture of a possible, but not limiting, predistortion system according to the present invention. The description will refer to the complex baseband signal representation with reference to the enclosed Figures from 1 to 7.

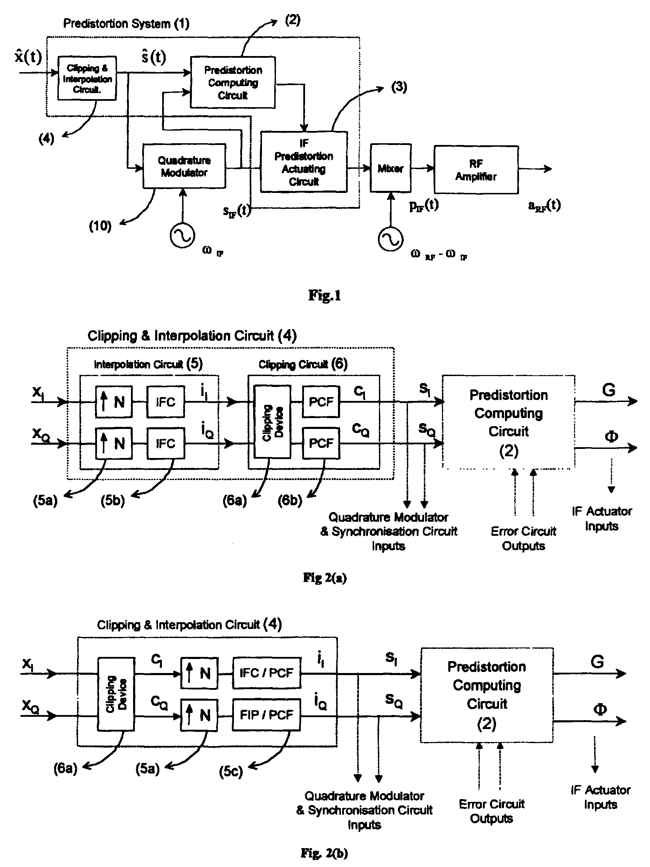

Fig.1 shows the scheme of an amplification system that employs a mixed baseband-IF Predistortion System (1), which includes a Clipping & Interpolation Circuit (4), a Predistortion Computing Circuit (2) and an IF Predistortion Actuating Circuit (3) that works at a frequency fIF = ωIF/2π that lies between the baseband and the transmitting frequency fRF = ωRF/2π at which the amplifier works.The depicted scheme is redundant. As a matter of fact, only one of the two Predistortion Computing Circuit (2) inputs is sufficient in order to make the system work.Moreover, also the Clipping & Interpolation Circuit (4) can be eliminated if the input signal x&(t) does not need such processing or if the combination of the clipping action with the predistortion action is not required.
Fig. 2(a) shows with greater detail the Clipping & Interpolation Circuit (4) scheme that is positioned before the Predistortion Computing Circuit (2).In this case the Interpolation Circuit (5) is positioned before the Clipping Circuit (6). In particular, the Interpolation Circuit (5) can be realised by a Filling Circuit (5a) that inserts (N-1) zeros, or (N-1) replica of each sample between the signal input samples, with N being the interpolation factor. The real interpolation function is performed in cascade through the action of the Interpolation Filter Circuit (IFC) (5b).The interpolated signal is elaborated by the Clipping Circuit (6) which firstly limits its maximum envelope (by means of the Clipping Device (6a)) and then eliminates the out band spectral regrowth (by means of the Post Clipping Filters Circuit (PCF) (6b)).
Fig.2(b) represents a Clipping & Interpolation Circuit (4) that is alternative to Fig. 2(a). In this case the Clipping & Interpolation Circuit (4) firstly performs clipping by means of a Clipping Device (6a), which is followed in cascade by a Filling Circuit (5a) that introduces zeros or input sample replica. The Filling Circuit (5a) is followed by the Filtering Circuit (5c) that simultaneously realises both the real interpolation filtering (IFC) and the post clipping filtering (PCF) of the signal outband spectral regrowth.

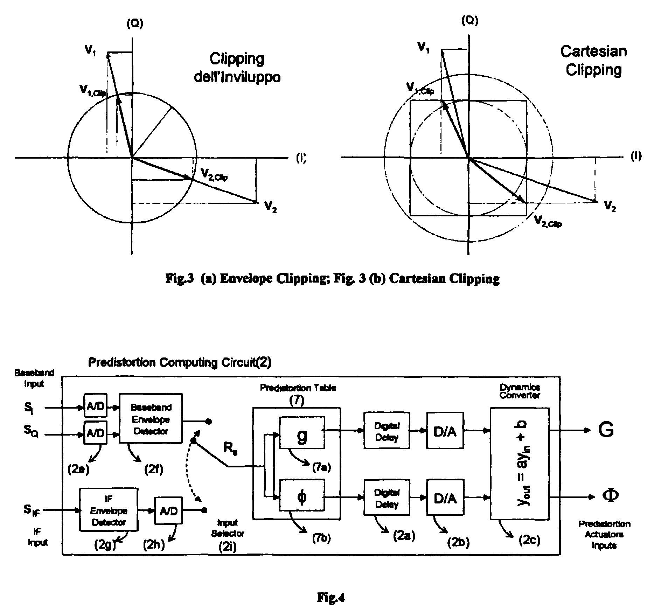

Fig. 3(a) and 3(b) graphically show the clipping operation that is performed on two general complex signals by the Clipping Device (5a).
Fig. 3(b) and 3(a) represent the action of a Cartesian Clipping Device and the action of an Envelope Clipping Device, respectively. The first device separately cuts each one of the single components (VI, VQ) over a certain value, while the second device simultaneously works on the single components (VI, VQ) by cutting them in such a way that the envelope is lower than a certain threshold.

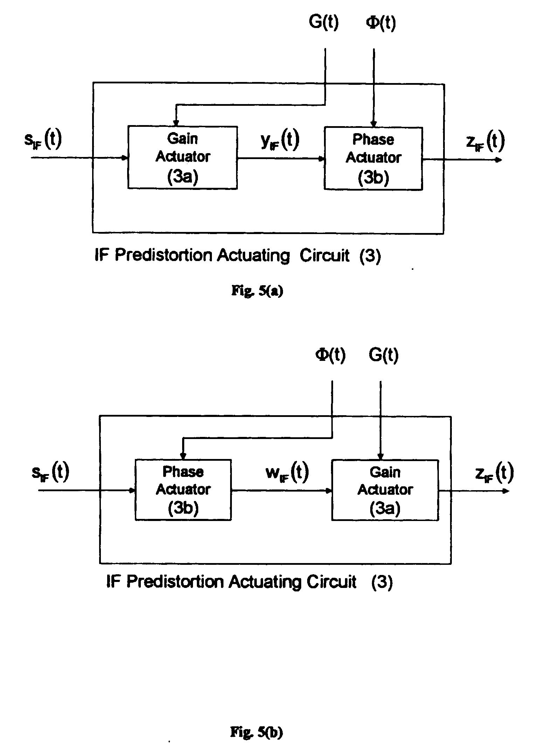

Fig. 4 shows a possible realisation scheme for the baseband Predistortion Computing Circuit (2). This scheme includes a circuit that extracts the input signal envelope.The input s(t) can be a baseband signal and consequently it can be represented by means of the complex notation as s(t) = sI(t) + jsQ(t). The input signal s(t) may also be modulated at a frequency fIF and it may be expressed by the relation:sIF(t) = sI(t)cos (2πfIFt)-sQ(t)sin(2πfIFt).In the first case the envelope Rs(t) of such a signal is extracted by a baseband Envelope Detector (2f) that performs the analytical operation expressed by the relationRs(t) = s2I(t)+s2Q(t).In the second case the signal envelope is extracted by an IF Envelope Detector (2g) that can be realised by analogue components as a classical envelope demodulator.If the Predistortion System (1) provides for both options, the Predistortion Computing Circuit (2) must include the Circuit (2f) and the Circuit (2g) as well as an Input Selector (2i).The Circuit (2) requires that the input signal envelope Rs is in digital format.If the input signal c(t) is not digital, it can be converted in digital format by the Analogue-to-Digital Converters (2e)(2h) that would not be present otherwise. The Rs envelope represents the signal by which the Predistortion Table (7) is addressed.The Predistortion Table (7) is organised in two Tables (7a) and (7b) in which the values that respectively determine the non linear gain (g or G) and the non linear phase (ϕ or Φ) of the IF Actuation Circuit (3) are stored.The function of the Circuits (2a), (2b) and (2c) is to adequately delay the Table (7) output control signals, convert them in analogue format and adapt their dynamics to those of the IF Actuation Circuit (3) controls.Two equivalent solutions to realise the IF Predistortion Actuation Circuit (3) are shown in Fig. 5(a) and 5(b).
The Fig.5(a) scheme provides that the Gain Actuator (3a) is positioned before the Phase Actuator (3b), while the two actuators invert their position in the Fig.5(b) scheme.The two analogue actuators are designed in such a way that one realises a phase modulation and the other one an amplitude modulation, generating the signals shown in Fig. (5a) and (5b) with analytical expression:sIF(t)=RS(t)cos[ωIFt+θS(t)]yIF(t)=G[RS(t)]·RS(t)·cos[ωIFt+θS(t)]wIF(t)=RS(t)·cos[ωIFt+θS(t)+Φ[RS(t)]]zIF(t)=RS(t)·G[RS(t)]cos[ωIFt+θS(t)+Φ[RS(t)]]

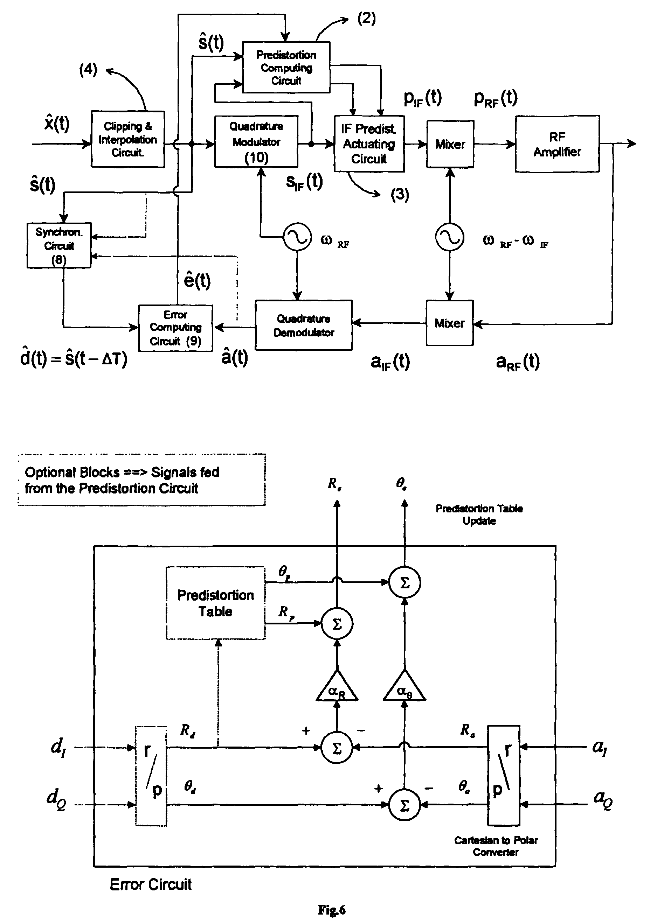

Fig.6 shows the scheme of an amplification system that includes the adaptation of the mixed baseband-IF Predistortion System (1).The scheme includes a Synchronisation Circuit (8) for the synchronisation of the Predistortion Computing Circuit (3) input signal s&(t) with the RF amplifier output signal â(t). A circuit (9) is also employed to determine the input-output error signal.

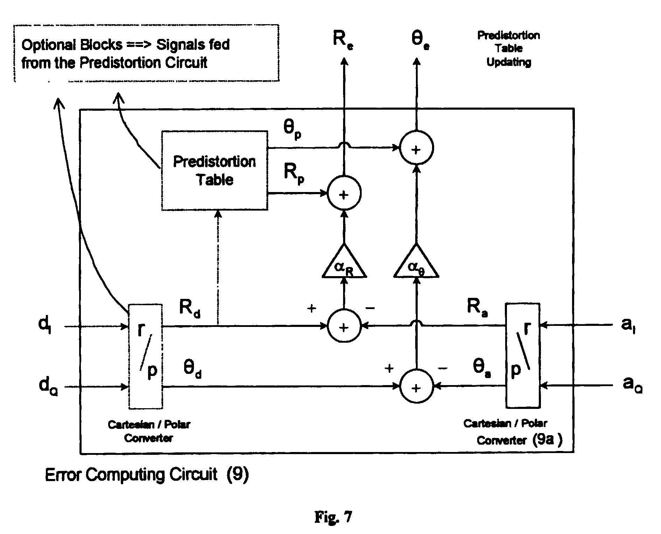

Fig.7 represents the logical scheme of a potential realisation of the Error Circuit (9).

The signal *x^{&}*(*t*) in Fig. 1 represents a complex digital signal at the input to the Predistortion System (1). After its conversion in digital format by the Analogue-to-Digital converters, the signal x^{&}(*t*) can be optionally oversampled by the Interpolation Circuit (5) of Fig. 2(a) or by the Circuit (5a) of Fig. 2(b), if the input sample frequency is not high enough to correctly represent it in a non-linear environment.

The Clipping Device (6a) shown Fig. 2(a) or Fig. 2(b) limits the peak-to-mean power ratio of the signal in order to avoid or reduce any other clipping or saturation phenomenon that could be introduced by the Predistortion Actuating Circuit (3) and/or the RF Amplifier.

The Clipping Device (6a) reduces the signal peak-to-mean power ratio constraining the envelope of the baseband signal inside a circle of the complex plane, as shown in Fig. 3(a), according to the technique called Envelope Clipping.

However, it is also possible to reduce the peak-to-mean power ratio by using other clipping strategies.

An alternative choice, for example, is to separately clip the In Phase and In Quadrature signal components as shown in Fig. 3(b) according to the technique called Cartesian Clipping.

The Cartesian Clipping reduces the signal envelope and introduces extra phase distortion on the signal, as shown in Fig. 3(b).

Moreover, the Cartesian Clipping does not exactly match with the Envelope Clipping introduced by the predistorted amplifier. As a consequence, the predistorted amplifier will introduce further clipping if the complex signal clipping is realised outside to the square that is circumscribed to the amplifier clipping circle. On the contrary, unneeded extra distortions will be introduced by the Cartesian Clipping if the clipping square is inscribed into the amplifier clipping circle, as shown in Fig. 3(b).

However, the Cartesian Clipping is easier and cheaper to implement and therefore can be considered as a good compromise between performance and costs.

Any kind of clipping strategy can be performed before or after the interpolation process (see Fig. 2(a) and Fig. 2(b)) if the Interpolation Circuit (5) is included in the Predistortion System (1).

The Clipping Circuit (6) positioned after the interpolation circuit represents the best solution in terms of achievable performance.

The other approach, nevertheless, is characterised by lower system complexity because the Post Clipping Filters Circuit (6b) acts as interpolation filter also.

The output *s^{&}*(*t*) of the Clipping & Interpolation Circuit (4) and its counterpart*s*_{IF}(*t*) at the output of the Quadrature Modulator (10) represent the input for the Predistortion Computing Circuit (2) and for the IF Predistortion Actuating Circuit (3), respectively.

The Predistortion Computing Circuit (2) shown in Fig. 4 employs the envelope*R*ₛ(*t*) extracted from the input signal to address the Predistortion Table (7) in order to generate two baseband signals *G*[*R*ₛ(*t*)] and Φ[*R*ₛ(*t*)], which control the operation of the IF Predistortion Actuating Circuit (3).

The IF Predistortion Actuating Circuit (3) of Fig. 5(a) or Fig. 5(b) use the control signals *G*[*R*ₛ(*t*)] and Φ[*R*ₛ(*t*)] to realise an amplitude and a phase modulation of the IF clipped signal *s*_{IF}(*t*) by respectively employing the Gain Actuator (3a) and the Phase Actuator (3b).

The control signals at the Tables (7a) and (7b) output are adequately delayed by using the Digital Delay Lines (2a) in such a way to synchronise them to the IF signals to be modulated.

The signals at the Digital Delay Lines (2a) output are reconverted in analogue format by the Digital-to-Analogue Converters (2b) and successively adapted to the control dynamics of their IF Actuators (3a) and (3b) by means of the Dynamic Converters (2c) that convert the control signal by means of the input-output relationship:yout = a·yin+b in which 'a' and 'b' are two opportune constants.

Moreover, the two IF Actuators (3a) and (3b) can interchange their position inside the Predistortion Actuating Circuit (3) without altering the predistortion strategy.

The two non-linear functions '*g*' and 'ϕ' stored in the Predistortion Tables (7) must be chosen in such a way that the IF Predistortion Actuating Circuit (3) will generate distortions that compensate the ones introduced by the amplifier.

Furthermore, the distortions must be different from those required to compensate only the amplifier AM/AM and AM/PM curves in such a way that they can also compensate the eventual non-linear behaviour of the analogue Actuators (3a) and (3b) and/or the non linear characteristic of the IF Envelope Detector (2g).

The Predistortion Computing Circuit (2) can also adapt the distortion introduced by it according to the changes caused by the amplifier ageing, the temperature variations, the channel or the power switching and so on.

A possible logical scheme for an adaptive predistortion system is described in Fig. 6, which includes both the timing and error circuit. The function of the Error Circuit (9) is to estimate the input-output non-linear error of the predistorted system and provide an error signal *ê*(*t*) to the Predistortion Computing Circuit (2).

The Error Circuit (9) can be realised in different ways. Fig. 7 shows one of the possible implementations of the error circuit, Where the envelope (a scaled replica) and the phase of the Predistortion Computing Circuit (2) input *s^{&}*(*t*) are subtracted from the correspondent amplifier output *â*(*t*).

The two error signals *R*ₑ(*t*) and *θ*ₑ(*t*) that are obtained are weighted by means of two real coefficients α_{R} and *α*_{θ} in order to provide the correcting terms for the values stored in the Tables (7a) and (7b), which are responsible for the predistortion that is introduced by the Circuit (3).

The two error signals are analytically expressed byRe = αR·[Ra-K·Rd]θe = αθ·[θa-θd] where K represents the desired linear gain for the predistorted amplifier.

The magnitude of the adaptation coefficients *α*_{R} and *α*_{θ} must be chosen as a compromise between adaptation speed and noise rejection.

The function of the Synchronisation Circuit (8) is to estimate the loop delay of the adaptive system and compensate it in order to allow the Error Circuit (9) to correctly compare the input *s^{&}*(*t*) of the Predistortion Computing Circuit (2) with the amplifier output *â*(*t*).

### REFERENCE

[1] N.M. Blachman, "Bandpass Nonlinearities.", IEEE Trans. on Inform. Theory, VOL. IT-10, April 1964, pp. 162-164.
[2] A.R. Kaye, D.A. George, M.J. Eric, "Analysis and Compensation of Bandpass Nonlinearities for Communications.", IEEE Trans. on Comm., VOL. COM-20, October 1972, pp. 965-972.
[3] P. Hetrakul, D.P. Taylor, "Compensation For Bandpass Nonlinearities in Satellite Communications", IEEE Trans. on Aerosp. Electr. Systems, Vol. AES-12 n.4, July 1976, pp. 509-514.
[4] A.A.M.Saleh and J.Salz, "Adaptive Linearisation of Power Amplifiers in Digital Radio Systems", The Bell Syst. Tech. Journal, Vol. 62, No. 4, April 1983, pp. 1019-1033.
[5] M. Faulkner, M. Johansson, "Adaptive Linearization Using Predistortion - Experimental Results", IEEE Trans. on Veh. Tech., Vol. VT-43 n.2, May. 1994, pp. 323-332.
[6] A. Wright, W. Durtler, "Experimental Performance of an Adaptive Digital Linearized Power Amplifier", IEEE Trans. on Veh. Tech. Vol. VT-41 n.4 Nov. 1992, pp. 395-400.
[7] Y.Levy, G. Karam, H. Sari, "Adaptation of a Digital Predistortion Technique based on Intersymbol Interpolation", IEEE Proc. GLOBECOM '95, pp. 145-150.
[8] T. Nojima, Y. Okamoto, "Predistortion Nonlinear Compensator For Microwawe SSB-AM System", ICC '80 Conf. Rec., Vol. 2, June 80, pp-33.2.1-33.2.6.
[9] T. Nojima, T. Konno, "Cuber Predistortion Lineariser for Relay Equipment in 800 MHz Band Land Mobile Telephone System", IEEE Trans. on Veh. Tech., Vol.VT-34 n.4, November 1985, pp.169-177.
[10] N. Imai, T. Nojima, T. Murase, "Novel Lineariser using Balanced Circulators and Its Application to Multilevel Digital Radio systems", IEEE Trans. on Microwave Theory and Techniques, Vol.37 n.8, August 1989, pp. 1237-1243.

## Claims

1. A mixed baseband-IF predistortion system for amplifiers linearisation characterised by at least one IF predistortion actuating circuit (3) and by at least a baseband predistortion computing circuit (2) that controls the circuit (3).
According to claim 1, a system characterised by the fact that it includes at least one clipping circuit (6) that is composed of a clipping device (6a) followed by at least a post-clipping filter (6b) or (5c).
According to claim 1, a system characterised by the fact that the said baseband predistortion computing circuit (2) includes at least: a table (7) to store the curves that allow for predistortion, a digital delay line (2a) and a digital-to-analogue converter (2b).
According to claim 3, a system characterised by the fact that the predistortion computing circuit (2) includes or uses a circuit for the envelope detection (2f) or (2g) to address the table (7).
According to claim 3, a system characterised by the fact that the predistortion computing circuit (2) addresses the table (7) by means of the baseband Cartesian components of the input signal.
According to claim 1, a system characterised by the fact that the IF predistortion actuating circuit (3) distorts the IF modulated input signal by at least one control signal that is provided by the baseband predistortion computing circuit (2).
According to claims 3, 4, 5 and 6, a system characterised by the fact that the output signal of the predistortion computing circuit (2) is composed of the table (7) outputs, after they have been converted in analogue format by the digital-to analogue converters (2b) and appropriately scaled by the dynamic converting circuits (2c).
According to claim 6, a system characterised by the fact that the IF predistortion actuating circuit (3) is composed of the cascade of a gain actuator (3a) and a phase actuator (3b), which modulate respectively the amplitude and the phase of the IF input signal by using two signals provided by the baseband predistortion computing circuit (2).
According to claim 1, a system characterised by the fact that it employs a circuit (5) for the interpolation of the input signal.
According to claim 9, a system characterised by the fact that the interpolation circuit (5) includes a device (5a) that introduces zeros or replica of the first sample between successive samples of the input signal, followed by the interpolation filters circuit (5b) or (5c).
According to claims 2 and 9, a system that is characterised by the fact that, in the clipping circuit (6), the clipping device (6a) is positioned before the interpolation circuit (5) and in which the post-clipping filters (5c) also act as interpolation filters.
According to claim 1, a system characterised by the fact that it employs an error computing circuit (9) that generates at least one signal to modify the distorting action introduced on the control signals of the predistortion computing circuit (2).
According to claims 2 and 3, a system characterised by the fact that the clipping circuit (6) is positioned both before the predistortion computing circuit (2) and the IF predistortion actuating circuit (3).
According to claim 2, a system characterised by the fact that the clipping device (6a) limits the input signal envelope without distorting its phase.
According to claim 2, a system characterised by the fact that the clipping device (6a) separately limits the Cartesian components of the input signal distorting either the envelope or the phase.
According to claim 12, a system characterised by the fact that the error computing circuit (9) generates the error signals by subtracting the envelope and phase of the amplifier baseband output signal from the corresponding components, at most scaled by a multiplication coefficient, at the input to the predistortion computing circuit (2).
According to claim 16, a system characterised by the fact that each error signal is multiplied by at least one weighting coefficient
According to claims 3, 12 e 16, a system characterised that it employs the error signal to update the content of the predistortion table (7).
According to claim 18, a system characterised by the fact that each value of the predistortion table (7) of the predistortion computing circuit (2), is updated for each value of its address, by summing to its original content the value of the error signal or a temporal mean that is performed on a number of values greater or equal to one, that are consecutively assumed by the error signal for each address value.
